# EUROPEAN PATENT APPLICATION

(11) **EP 4 654 254 A1**
(43) Date of publication of application: **26.11.2025**
(21) Application number: 24744565.3
(22) Date of filing: 11.01.2024
(51) Int. Cl.: H01L 21/683, H01L 21/3065

(54) **ELECTROSTATIC CHUCK**

(30) Priority: 18.01.2023 JP 2023005808
(71) Applicant: Tomoegawa Corporation, Tokyo 104-8335 (JP)
(72) Inventor: ADACHI TOMIOKA, Ayana, Shizuoka-shi, Shizuoka 424-0831 (JP); SAKUMOTO, Yukinori, Shizuoka-shi, Shizuoka 424-0831 (JP)
(74) Representative: V.O.
(86) International application number: PCT/JP2024/000429
(87) International publication number: WO 2024/154642

(57) **Abstract**

Provided is an electrostatic chuck capable of suppressing a temperature variation of an adsorbed object. The electrostatic chuck includes an internal electrode (13) having a thickness, and dielectric layers (resin layers (12), ceramic layers (14), and the like) provided on both sides of the internal electrode (13) in a thickness direction, and the internal electrode (13) has a cooling flow path (20) extending in a direction different from the thickness direction.

## Description

### TECHNICAL FIELD

The present invention relates to an electrostatic chuck.

### BACKGROUND ART

When a semiconductor integrated circuit is manufactured using a semiconductor wafer or when a liquid crystal panel is manufactured using a insulating substrate such as a glass substrate, a film, or the like, a base material such as a semiconductor wafer, a glass substrate, an insulating substrate, or the like, must be adsorbed and held in a predetermined area. A mechanical chuck or a vacuum chuck has a problem such as difficulty of holding a base material (an adsorbed object) uniformly and inability to be used in a vacuum. Here, in recent years, an electrostatic chuck has been used to hold the adsorbed object.

Main parts of the electrostatic chuck are a conductive support member which serves as an internal electrode and a dielectric layer made of a dielectric material which covers the conductive support member. The adsorbed object can be adsorbed by the main parts. When a voltage is applied to an internal electrode of the electrostatic chuck, a potential difference is generated between the adsorbed object and the conductive support member, which results in electrostatic adhesion between the dielectric layers. Accordingly, the adsorbed object is supported approximately flat against the conductive support member.

Patent Document 1 discloses that a gas supply hole configured to supply a cooling gas and a groove that becomes a flow path for the cooling gas are formed in an adhesive surface. In addition, Patent Document 2 discloses that a distribution space of a gas is formed in an insulating material that covers a back surface of an electrode of an electrostatic chuck and a gas vent hole is connected to the distribution space.

### Citation List

### Patent Document

Patent Document 1: Japanese Unexamined Patent Application, First Publication No. 2010-34256
Patent Document 2: Japanese Unexamined Patent Application, First Publication No. H05-21585

### SUMMARY OF INVENTION

### Technical Problem

The electrostatic chucks in the related art perform cooling by supplying a cooling gas between the adhesive surface and the adsorbed object, resulting in poor cooling performance and large temperature variation of the adsorbed object.

An object of the present invention is directed to providing an electrostatic chuck capable of suppressing temperature variation of an adsorbed object.

### Solution to Problem

A first aspect of the present invention is an electrostatic chuck including: an internal electrode having a thickness, and dielectric layers provided on both sides of the internal electrode in a thickness direction, the internal electrode having a cooling flow path extending in a direction different from the thickness direction.

According to a second aspect of the present invention, in the first aspect, a layered structure constituted by the internal electrode and the dielectric layer is provided, and the cooling flow path extends in a layer direction of the layered structure.

According to a third aspect of the present invention, in the first or second aspect, in a plane perpendicular to the thickness direction, an area of the internal electrode is equal to or greater than 30% of an area of a region in which an object is able to be adsorbed by the electrostatic chuck, and a total cross-sectional area of the cooling flow path is equal to or greater than 30% of an area of the internal electrode.

According to a fourth aspect of the present invention, in any one of the first to third aspects, in dielectric layers provided on both sides in the thickness direction, the cooling flow path communicates with only one dielectric layer provided on one side of the internal electrode in the thickness direction.

According to a fifth aspect of the present invention, in any one of the first to fourth aspects, a second cooling flow path passing through the internal electrode in the thickness direction is further provided from one side of the internal electrode in the thickness direction toward the other side of the internal electrode in the thickness direction at a position different from the cooling flow path.

According to a sixth aspect of the present invention, in any one of the first to fifth aspects, the dielectric layer includes a resin layer on at least one side of the internal electrode in the thickness direction.

According to a seventh aspect of the present invention, in any one of the first to sixth aspects, the dielectric layer includes a resin film layer on at least one side of the internal electrode in the thickness direction.

According to an eighth aspect of the present invention, in any one of the first to seventh aspects, the dielectric layer has a ceramic layer on a side where an object adsorbed by the electrostatic chuck is disposed.

According to a ninth aspect of the present invention, in the eighth aspect, the ceramic layer may or may not have gas vent holes in an adhesive surface of the object, but has no irregularities other than the gas vent holes.

According to a tenth aspect of the present invention, in any one of the first to ninth aspects, the electrostatic chuck further includes a base provided on one side of the internal electrode in the thickness direction via the dielectric layer.

### Advantageous Effects of Invention

According to the present invention, it is possible to suppress temperature variation of an adsorbed object.

### BRIEF DESCRIPTION OF DRAWINGS

[FIG. 1] A cross-sectional view showing an electrostatic chuck of an embodiment.
[FIG. 2] A cross-sectional view showing a modified example in an adhesive surface of the electrostatic chuck.
[FIG. 3] A cross-sectional view showing an example of a place where a cooling flow path passes through an dielectric layer.
[FIG. 4] A cross-sectional view showing a first layout example of a cooling flow path in an internal electrode.
[FIG. 5] A cross-sectional view showing a second layout example of the cooling flow path in the internal electrode.
[FIG. 6] A cross-sectional view showing a third layout example of the cooling flow path in the internal electrode.
[FIG. 7] A cross-sectional view showing a fourth layout example of the cooling flow path in the internal electrode.

### DESCRIPTION OF EMBODIMENTS

Hereinafter, the present invention will be described on the basis of a suitable embodiment. Further, in drawings, dimensional ratios of components may not be the same as in reality.

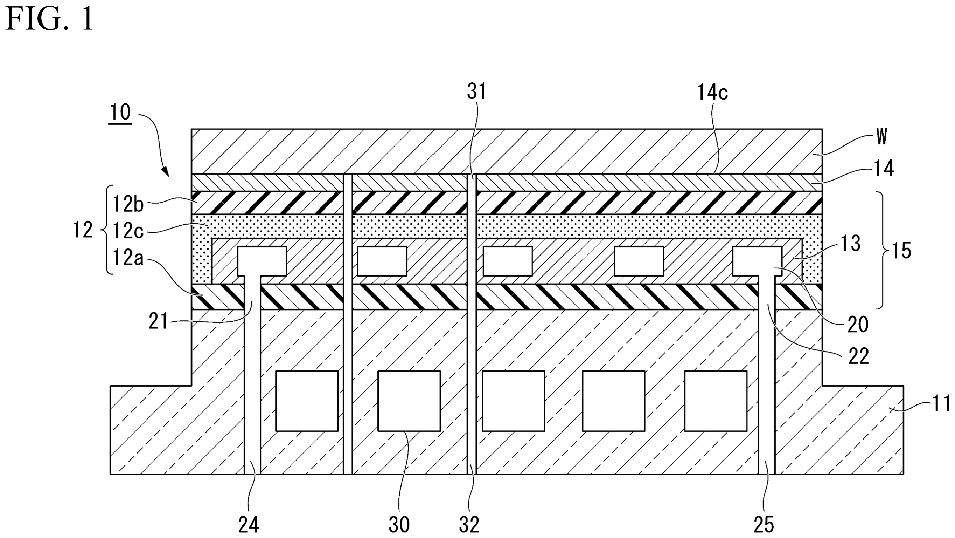

FIG. 1 shows a schematic cross-sectional view of an electrostatic chuck 10 of the embodiment. The electrostatic chuck 10 can be used in an adsorption device configured to adsorb an adsorbed object W. The adsorbed object W is an object adsorbed by the electrostatic chuck 10. A material of the adsorbed object W is not particularly limited as long as it is capable of electrostatic adsorption, but examples include semiconductors such as silicon (Si), glass, ceramics, and insulating materials. The adsorbed object W may be a semiconductor wafer.

The electrostatic chuck 10 includes an internal electrode 13. The internal electrode 13 may be an adsorption electrode used to adsorb the adsorbed object W. The number of the internal electrodes 13 is not particularly limited, and at least one must be included in the electrostatic chuck 10. When the electrostatic chuck 10 is activated, the adsorbed object W is adsorbed to an adhesive surface 14c. The adhesive surface 14c is preferably formed on a ceramic layer 14 having excellent heat resistance.

In particular, while not shown, a power supply unit configured to supply power to the internal electrode 13 is provided on a base 11 of the electrostatic chuck 10. The base 11 can be made of, for example, ceramics such as silicon carbide (SiC) or the like, metals such as aluminum or the like, and alloys such as stainless steel or the like. The base 11 is provided on one side of the internal electrode 13 in the thickness direction. Specifically, the base 11 is disposed on the side opposite to the side to which the adsorbed object W is adsorbed.

The internal electrode 13 is not particularly limited and can be formed, for example, from a layered conductor. The conductor of the internal electrode 13 is not particularly limited, but for example, one or more metals such as copper, aluminum, gold, silver, platinum, chromium, nickel, tungsten, and the like, are suitably used. The conductor of the internal electrode 13 may be a metal containing at least one of these metals.

On both sides of the internal electrode 13 in the thickness direction, dielectric layers such as a resin layer 12 and the ceramic layer 14 are provided. The dielectric layer is an electrical insulating layer. The internal electrode 13 and the dielectric layer such as the resin layer 12 may form a layered structure 15.

The internal electrode 13 has a cooling flow path 20 extending in a direction different from the thickness direction. It is preferable that the cooling flow path 20 extending in the layer direction of the layered structure 15 be formed inside the internal electrode 13. Inside the internal electrode 13, the cooling flow paths 20 are widely distributed at the same distance from the adhesive surface 14c, thereby suppressing the temperature variation of the adsorbed object W.

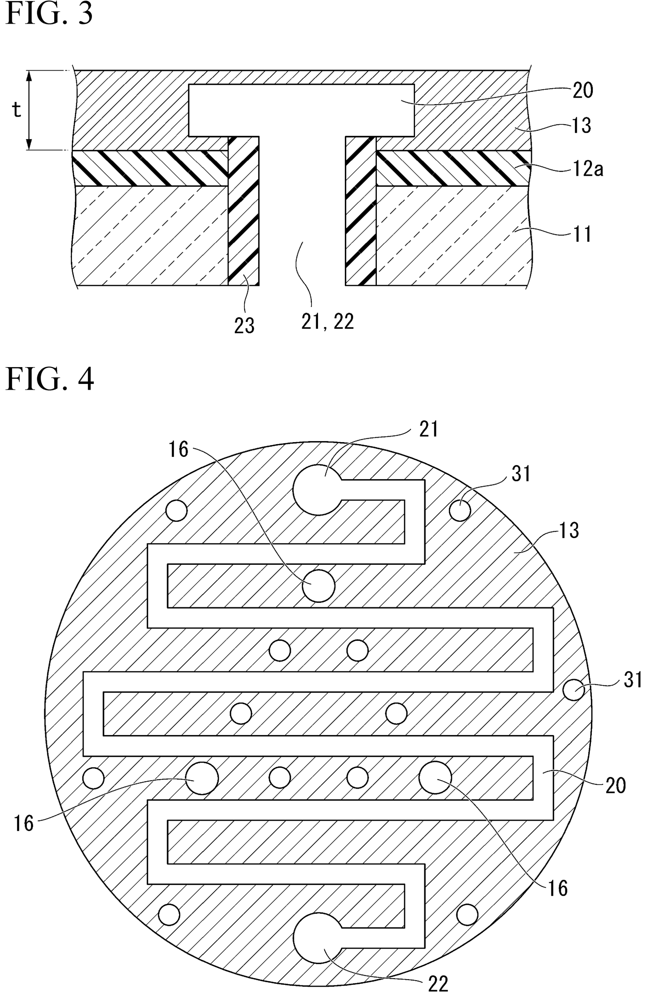

The thickness direction of the internal electrode 13 is a direction along a thickness t (see FIG. 3) of the internal electrode 13. A layer direction of the layered structure 15 may be a direction perpendicular to the thickness direction of the internal electrode 13, but it may be any direction that allows the cooling flow path 20 to extend within the range of the thickness t of the internal electrode 13. In FIGS. 1 to 3, the thickness direction is the upward/downward direction of the drawings, and the layer direction is the leftward/rightward direction of the drawings. The cooling flow path 20 may be formed linearly along the layer direction, or may be formed in a curved line shape, a curved surface shape, a bent shape, a zigzag shape, etc. within the range of the thickness t of the internal electrode 13.

The thickness t of the internal electrode 13 is not particularly limited, but may be, for example, 50 µm to 1 mm, or may be 100 µm or more. Within the layered structure 15, the internal electrode 13 may be disposed at two or more locations. The plurality of internal electrodes 13 may overlap in the thickness direction. The plurality of internal electrodes 13 may be disposed in the layer direction.

In a plane perpendicular to the thickness direction of the internal electrode 13, it is preferable that the area of the internal electrode 13 be a certain percentage or more relative to the area of the region of the electrostatic chuck 10 capable of adsorbing the adsorbed object W (hereinafter referred to as "an adsorbing area"). In addition, it is preferable that the total cross-sectional area of the cooling flow path 20 extending within the range of the thickness t of the internal electrode 13 to the area of the internal electrode 13 be a certain ratio or greater.

When the area of the internal electrode 13 is S1 and the area of the adsorbing area is S2, S1 is preferably 30% or more of S2, more preferably 50% or more of S2, and may be 80% or more or 90% or more of S2, or may be 99% or less of S2. In addition, when the area of the internal electrode 13 is S1 and the sum of the cross-sectional areas of the cooling flow path 20 is S3, S3 is preferably 30% or more of S1, more preferably 50% or more of S1, and may be 80% or more or 90% or more of S1, or may be 99% or less of S1. Since the cooling flow path 20 is surrounded by the internal electrode 13, S3 is less than S1. As mentioned above, the areas S1, S2 and S3 are areas in a plane perpendicular to the thickness direction of the internal electrode 13.

Since it is preferable that the area of the adsorption area be approximated to the area of the adsorbed object W, when the same adsorbed object W is disposed across the plurality of adhesive surfaces 14c, the adsorbing area may also include regions between the plurality of adhesive surfaces 14c that do not have the adhesive surface 14c. In this viewpoint, the area of the adsorbing area includes the area of the adhesive surface 14c, but each point on a line segment connecting any two arbitrary points included in the adhesive surface 14c is also included in the adsorbing area. Here, "the line segment connecting the two points" means a section of a straight line passing through those two points, with those two points being both ends of the section. For example, when only the convex portion of the adhesive surface 14c, including convex and concave portions, contacts the adsorbed object W, the adsorbing area may include not only the area of the convex portions but also the region of the concave portions that exists between the convex portions.

The cooling flow path 20 is used as a flow path for a coolant. The coolant is a cooling medium. The cooling flow path 20 is provided with an inlet port 21 and an outlet port 22 for the coolant. When the coolant is circulated through the cooling flow path 20, the heat of the electrostatic chuck 10 is conducted to the coolant, and the electrostatic chuck 10 is cooled. When the coolant is discharged from the cooling flow path 20 to the outside of the electrostatic chuck 10, excess heat is discharged from the electrostatic chuck 10 along with the coolant.

It is preferable that the cooling flow path 20 communicates with only one side of the internal electrode 13 in the thickness direction among the dielectric layers such as the resin layer 12 or the like provided on both sides in the thickness direction. In the example shown, the inlet port 21 and the outlet port 22 are located on the side of the base 11, i.e., a side opposite to the adsorbed object W.

When the inlet port 21 and the outlet port 22 are disposed in the thickness direction, the inlet port 21 and the outlet port 22 can be formed more easily than when the inlet port 21 and the outlet port 22 are disposed in the layer direction. Even if the diameters of the inlet port 21 and the outlet port 22 are large, the thickness t of the internal electrode 13 can be suppressed.

When the inlet port 21 and the outlet port 22 are disposed on the side of the base 11, design and manufacture are easier than when the inlet port 21 and the outlet port 22 are disposed on the side of the adsorbed object W. While described below in detail, it is preferable that a mechanism configured to supply coolant to the inlet port 21 or a mechanism configured to recover coolant from the outlet port 22 is disposed on the side of the base 11.

As shown in FIG. 3, an insulating material 23 may be provided on the inner surfaces of the inlet port 21 and the outlet port 22 extending toward the base 11. The insulating material includes, but is not limited to, ceramics such as alumina or the like and resins such as polyether ether ketone (PEEK) or the like. The insulating material 23 may be formed in, for example, a cylindrical shape, a wall shape, or the like.

The coolant circulated through the cooling flow path 20 may be liquid or gas. The coolant, which is liquid at a room temperature, may become a gas inside the electrostatic chuck 10. The coolant that becomes liquid at an internal temperature of the electrostatic chuck 10 may be used. Examples of the coolant include, but are not limited to, insulating oil, organic solvents, and alternative fluorocarbons.

Examples of the insulating oils for coolants include FLUORINERT (Registered Trademark), GALDEN (Registered Trademark), NOVEC (Registered Trademark), and the like. Organic solvents for the coolants include methanol, ethanol, ethylene glycol, glycerin, and the like.

Alternative fluorocarbons for coolants include hydrochlorofluorocarbons (HCFCs), hydrofluorocarbons (HFCs), and the like.

Inert gases such as helium, argon, nitrogen, and the like, may also be used as coolants.

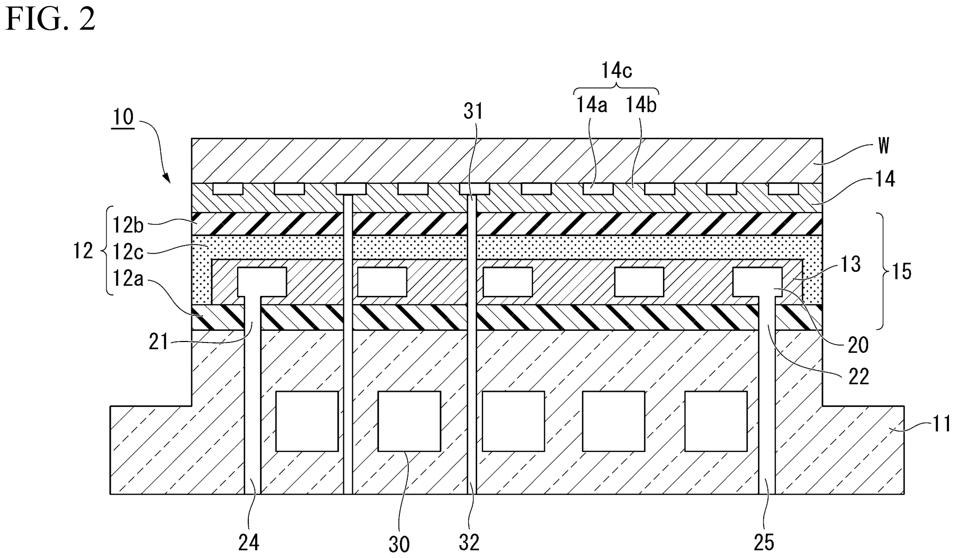

As shown in FIG. 1 and FIG. 2, a coolant supply flow path 24 is connected to the inlet port 21, and a coolant collecting flow path 25 is connected to the outlet port 22. The coolant supply flow path 24 and the coolant collecting flow path 25 extend downwardly through the layered structure 15 to the base 11. In particular, while not shown, a mechanism is provided for supplying coolant from the coolant supply flow path 24 to the cooling flow path 20, and a mechanism is provided for recovering coolant from the cooling flow path 20 via the coolant collecting flow path 25.

The base 11 may be provided with a base cooling flow path 30 as a flow path for circulating a coolant for cooling the base 11. The number, shape, dimension, layout, and so on, of the base cooling flow path 30 can be set appropriately.

Within the base 11, the coolant supply flow path 24 and the coolant collecting flow path 25 are located at different positions from the base cooling flow path 30. The coolant circulated through the base cooling flow path 30 is not particularly limited, but may be the same type of coolant as that used in the cooling flow path 20, or may be a coolant different from that used in the cooling flow path 20.

The electrostatic chuck 10 may have a second cooling flow path 32 penetrating the internal electrode 13 in the thickness direction from one side of the internal electrode 13 in the thickness direction to the other side of the internal electrode 13 in the thickness direction, at a position different from the cooling flow path 20. Within the base 11, the second cooling flow path 32 is disposed at a different position from the base cooling flow path 30.

In the example shown in FIG. 1 and FIG. 2, for simplicity of illustration, the coolant supply flow path 24, the coolant collecting flow path 25, and the second cooling flow path 32 are shown on the same cross section. In an actual device configuration, these positional relations can be set arbitrarily. The coolant supply flow path 24, the coolant collecting flow path 25, the base cooling flow path 30, and the second cooling flow path 32 can be arranged with appropriate intervals within the base 11 so that they operate independently of each other.

At the end where the second cooling flow path 32 penetrates the internal electrode 13 in the thickness direction, a gas vent hole 31 is formed which reaches the adhesive surface 14c. The gas vent hole 31 is a point where the second cooling flow path 32 penetrates the layered structure 15 including the internal electrode 13, and the coolant gas supplied from the base 11 side flows therethrough.

Helium (He) gas is generally used as the coolant gas supplied to the second cooling flow path 32. The coolant gas ejected from the gas vent hole 31 comes into contact with the adsorbed object W, enabling direct cooling.

However, except for the gas vent hole 31, the second cooling flow path 32 and the base cooling flow path 30 are primarily disposed inside the base 11. For this reason, with only the second cooling flow path 32 and the base cooling flow path 30, the distance to the adsorbed object W is long (e.g., 100 µm to 3 mm), and the temperature response during cooling is slow.

In the electrostatic chuck 10 of the embodiment, the distance from the cooling flow path 20 formed in the internal electrode 13 to the adsorbed object W can be shortened (for example, 50 to 200 µm). Accordingly, it is possible to improve the temperature response during cooling.

To maintain the temperature of the adsorbed object W within a predetermined range, for example, control may be performed such as increasing the flow rate of the coolant when the temperature of the adsorbed object W rises above a target value, and decreasing the flow rate of the coolant when the temperature of the adsorbed object W falls below the target value. If the distance from the cooling flow path 20 to the adsorbed object W is short, the time required for heat conduction is also short, and thus, the temperature response is improved.

If the electrostatic chuck 10 has the second cooling flow path 32, the adhesive surface 14c may be provided with a concave portion 14a and a convex portion 14b, as shown in FIG. 2. Since a gap is formed by the concave portion 14a, the coolant gas ejected from the gas vent hole 31 can easily flow between the adsorbed object W and the ceramic layer 14. If the electrostatic chuck 10 does not have the second cooling flow path 32, the second cooling flow path 32 and the gas vent hole 31 can be omitted.

The ceramic layer 14 having the adhesive surface 14c may or may not have the gas vent hole 31, but it is preferable that the ceramic layer 14 has no irregularities other than the gas vent hole 31. Because the adhesive surface 14c does not have the concave portion 14a and the convex portion 14b, the effect of a decrease in heat conduction rate due to the presence of gas in the concave portion 14a can be suppressed, and heat conduction from the adsorbed object W adsorbed to the adhesive surface 14c to the cooling flow path 20 can be promoted. In addition, the adhesive surface 14c comes into full contact with the adsorbed object W, thereby improving the temperature response.

The number of the cooling flow paths 20 formed in the internal electrode 13 is not particularly limited, and may be one or two or more. The number of the inlet ports 21 provided in one cooling flow path 20 is not particularly limited, and may be one or two or more, for example, five or ten. The number of the outlet ports 22 provided in one cooling flow path 20 is not particularly limited, and may be one or two or more, for example, five or ten.

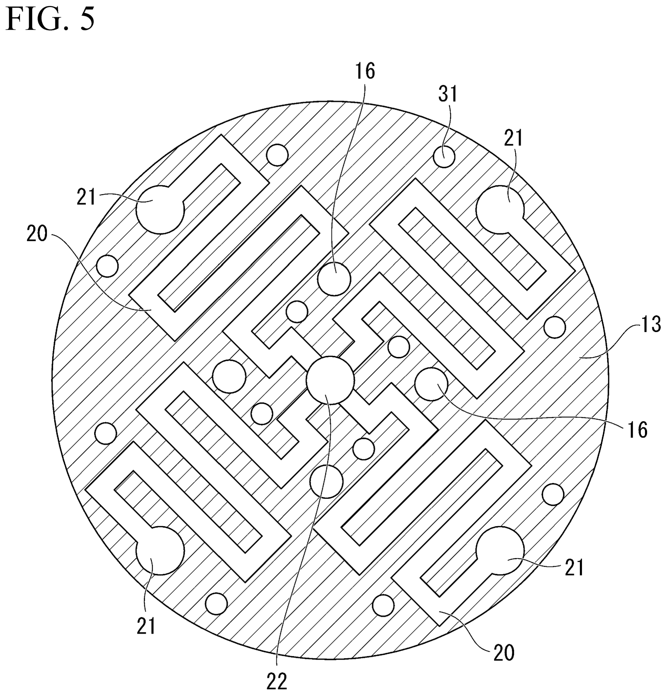

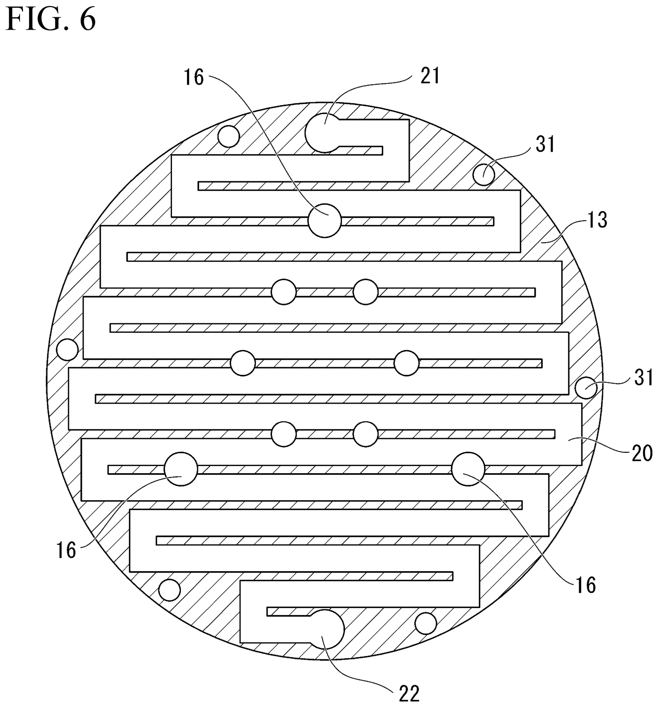

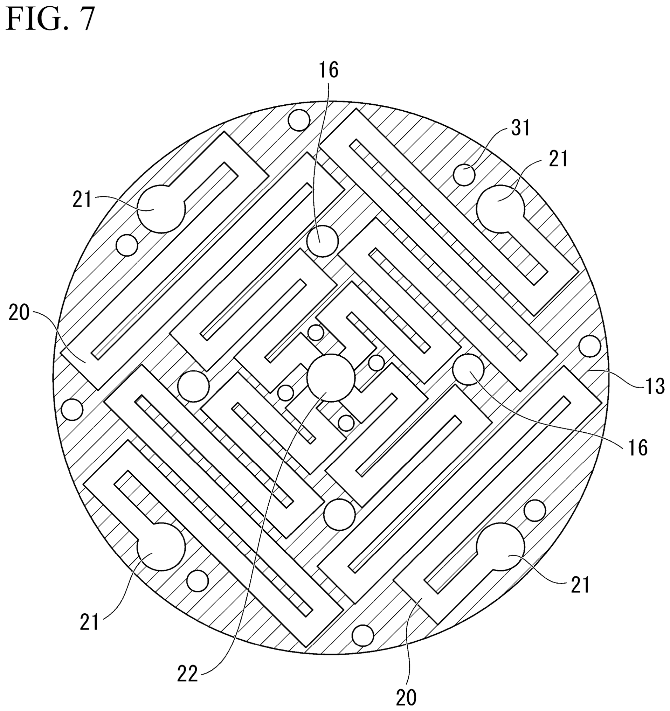

FIG. 4 and FIG. 6 show an example in which the cooling flow path 20 is formed in a serpentine between the inlet port 21 and the outlet port 22. FIG. 5 and FIG. 7 show an example in which the cooling flow path 20 is formed in a serpentine shape between the plurality of inlet ports 21 disposed in an outer circumferential portion and one outlet port 22 disposed in a central portion. In particular, while not shown, the cooling flow path 20 may be formed in a serpentine shape between one inlet port 21 disposed in the central portion and the plurality of outlet ports 22 disposed in the outer circumferential portion.

The internal electrode 13 may have a positioning hole 16. The positioning hole 16 can be used, for example, when the layered structure 15 including the internal electrode 13 is attached to the base 11. There are three positioning holes 16 in FIG. 4 and FIG. 6, and four positioning holes 16 in FIG. 5 and FIG. 7. The number, shape, dimension, layout, and so on, of the positioning hole 16 can be set appropriately.

When the internal electrode 13 has the positioning hole 16, it is preferable to arrange the cooling flow path 20 at a position that avoids the positioning hole 16. In addition, when the internal electrode 13 has the gas vent hole 31, it is preferable to arrange the cooling flow path 20 at a position that avoids the gas vent hole 31.

In the example shown in FIGS. 4 to 7, for simplicity of illustration, the cooling flow path 20 has a substantially uniform width, and the bends are at substantially right angles. The cooling flow path 20 may be bent at an appropriate angle, may be curved, or may have a portion where the flow path cross-sectional area is partially different. These designs can effectively avoid the positioning hole 16 or the gas vent hole 31, and achieve uniform or localized enhancement of cooling performance in the plane.

The method for forming the cooling flow path 20 inside the internal electrode 13 is not particularly limited, but it is sufficient to form a cavity with both ends open inside a metal material. For example, the cooling flow path 20 may be formed by removing a portion of the material from inside the internal electrode 13 by machining, etching, or the like. The internal electrode 13 including the cooling flow path 20 may be produced by molding a material around the cooling flow path 20 by die casting of molten metal, sintering of powder metal, or the like.

The internal electrode 13 may be fabricated from a combination of a plurality of electrode materials. For example, when the first electrode material and the second electrode material are combined in the thickness direction, through-holes that become the inlet port 21 and the outlet port 22 may be formed in the first electrode material, and a groove that becomes the cooling flow path 20 may be machined on the surface of the second electrode material facing the first electrode material. Alternatively, a groove that becomes the cooling flow path 20 may be machined on the surface of the first electrode material facing the second electrode material.

When the first electrode material, the second electrode material and the third electrode material are combined in the thickness direction, for example, through-holes that become the inlet port 21 and the outlet port 22 may be formed in the first electrode material, and a slot that becomes the cooling flow path 20 may be formed in the second electrode material. The slot (long hole) is a through-hole that extends along a path connecting both ends. The third electrode material may seal a bottom portion of the cooling flow path 20 (the side opposite to the inlet port 21 and the outlet port 22) using a completely enclosed planar material.

It is preferable that both ends of the cooling flow path 20 are located at the inlet port 21 or the outlet port 22. Accordingly, the flow of coolant flowing from the inlet port 21 into the cooling flow path 20 and flowing from the cooling flow path 20 to the outlet port 22 can be stabilized. Forming the cooling flow path 20 in a serpentine (meander) shape is preferable because it increases the watershed area adjacent to the cooling flow path 20.

When the plurality of cooling flow paths 20 branch off from one inlet port 21, both ends of the cooling flow path 20 may be located at the outlet port 22. When the plurality of cooling flow paths 20 merge into one outlet port 22, both ends of the cooling flow path 20 may be the inlet port 21. If the plurality of cooling flow paths 20 branch off from one inlet port 21 and then merge into one outlet port 22, the cooling flow paths 20 may be annular without both ends.

The planar material used for the plurality of electrode materials is not particularly limited, but may be, for example, a metal plate, a metal foil, or the like. Methods for joining a plurality of electrode materials include, but are not limited to, soldering, brazing, welding, pressure welding, etc.

It is preferable that the resin layer 12 is included on at least one side of the internal electrode 13 in the thickness direction. The resin layer 12 may be included on both sides of the internal electrode 13 in the thickness direction, or may be in contact with the internal electrode 13. Examples of the resin layer 12 include resin film layers 12a and 12b molded into a film shape, an adhesive resin layer 12c that can be adhered to the internal electrode 13, and the like.

The material forming the resin film layers 12a and 12b is not particularly limited as long as it is an electrically insulating resin, but examples of the material include polyesters such as polyethylene terephthalate, polyolefins such as polyethylene, polyimides, polyamides, polyamideimides, polyethersulfones, polyphenylene sulfides, polyetherketones, polyetherimides, cellulose-based resins such as triacetyl cellulose, silicone rubber, and fluorine-based resins such as polytetrafluoroethylene.

It is preferable that the resin film layers 12a and 12b are included on at least one side of the internal electrode 13 in the thickness direction. The resin film layers 12a and 12b may be included on either side of the internal electrode 13 in the thickness direction. The resin film layers 12a and 12b may be laminated to both sides of the layered structure 15. The resin film layers 12a and 12b may contain additives such as inorganic fillers or the like.

The resin that constitutes the adhesive resin layer 12c is not particularly limited as long as it is an electrically insulating resin, but examples of the resin include epoxy resin, phenolic resin, styrene block copolymer, polyamide resin, acrylonitrile-butadiene copolymer, polyester resin, polyimide resin, silicone resin, amine compound, bismaleimide compound, and the like. These resins may be used alone or in combination of two or more.

It is preferable that the adhesive resin layer 12c is included on at least one side of the internal electrode 13 in the thickness direction. The adhesive resin layer 12c may be included on both sides of the internal electrode 13 in the thickness direction. The adhesive resin layer 12c may be used to bond the internal electrode 13 to the resin film layers 12a and 12b. In particular, while not shown, it is preferable that the base 11 and the internal electrode 13 are adhered to each other by the adhesive resin layer 12c. In addition, when the resin film layer 12b is present on the side of the base 11 of the internal electrode 13, the base 11 and the resin film layer 12b may be bonded together via the adhesive resin layer 12c. The adhesive resin layer 12c may contain additives such as inorganic fillers or the like.

An outer circumferential portion of the internal electrode 13 may be covered with the adhesive resin layer 12c. When the plurality of internal electrodes 13 are arranged in the layer direction, the spaces between the internal electrodes 13 may be filled with the adhesive resin layer 12c. The adhesive resin layer 12c may be formed by applying, drying or curing a liquid resin composition.

The resin layer 12 may contain inorganic filler to improve the heat conductivity of the resin. Although there is no particular limitation on inorganic fillers, metal oxides, metal nitrides, metal carbides, etc. are preferred, and more specific examples include alumina, yttria, silicon carbide, boron nitride, aluminum nitride, etc. These inorganic fillers may be used alone or in combination of two or more.

The material constituting the ceramic layer 14 is not particularly limited, but examples of the material include boron nitride, aluminum nitride, zirconium oxide, silicon oxide, tin oxide, indium oxide, quartz glass, soda glass, lead glass, borosilicate glass, zirconium nitride, titanium oxide, and the like. These ceramic materials may be used alone or in combination of two or more.

It is preferable that the ceramic layer 14 is included on at least one side of the internal electrode 13 in the thickness direction. The ceramic layer 14 may be included on both sides of the internal electrode 13 in the thickness direction. The electrostatic chuck 10 in the example shown has the ceramic layer 14 on the side on which the adsorbed object W is placed. The ceramic layer 14 includes the adhesive surface 14c.

An adhesive layer (not shown) may be laminated between the resin layer 12 and the ceramic layer 14 to bond these layers together. The adhesive layer preferably contains an insulating resin and a filler.

The insulating resin (polymeric substances) used in the adhesive layer may be either organic insulating resin or inorganic insulating resin. Examples of organic insulating resins include, but are not limited to, polyimide resin, epoxy resin, acrylic resin, and the like. Examples of inorganic insulating resins include, but are not limited to, silane resin, silicone resin, and the like.

It is preferable that the adhesive layer contains polysilazane. Examples of polysilazane include those known in the art. The polysilazane may be an organic polysilazane or an inorganic polysilazane. These polysilazane materials may be used alone or in combination of two or more.

The filler used in the adhesive layer may be a powder-like inorganic filler or a fibrous filler. The inorganic filler is not particularly limited, but is preferably at least one or more types selected from metal oxides such as alumina, silica, yttria, and the like. The fibrous filler is preferably at least one or more types selected from plant fibers such as pulp, inorganic fibers such as alumina, organic fibers such as synthetic fibers, or the like. The synthetic fibers include materials made by fiberizing aramid resin, or organic resins such as polytetrafluoroethylene, or the like. Further, the adhesive resin layer 12c is not essential; for example, in the electrostatic chuck 10 of FIG. 1, it is possible to have a structure in which the adhesive resin layer 12c is not provided and the resin film layer 12a is directly adhered to the internal electrode 13.

Hereinabove, the present invention has been described based on the preferred embodiment, but the present invention is not limited to the above-mentioned embodiment, and various modifications are possible without departing from the spirit of the present invention.

### INDUSTRIAL APPLICABILITY

According to the present invention, it is possible to provide an electrostatic chuck capable of suppressing a temperature variation of an adsorbed object.

### REFERENCE SIGNS LIST

W Adsorbed object
10 Electrostatic chuck
11 Base
12 Resin layer
12a, 12b Resin film layer
12c Adhesive resin layer
13 Internal electrode
14 Ceramic layer
14a Concave portion
14b Convex portion
14c Adhesive surface
15 Layered structure
16 Positioning hole
20 Cooling flow path
21 Inlet port
22 Outlet port
23 Insulating material
24 Coolant supply flow path
25 Coolant collecting flow path
30 Base cooling flow path
31 Gas vent hole
32 Second cooling flow path

## Claims

1. An electrostatic chuck comprising: an internal electrode having a thickness, and dielectric layers provided on both sides of the internal electrode in a thickness direction,
wherein the internal electrode has a cooling flow path extending in a direction different from the thickness direction.

2. The electrostatic chuck according to claim 1, wherein a layered structure constituted by the internal electrode and the dielectric layer is provided, and the cooling flow path extends in a layer direction of the layered structure.

3. The electrostatic chuck according to claim 1, wherein, in a plane perpendicular to the thickness direction, an area of the internal electrode is equal to or greater than 30% of an area of a region in which an object is able to be adsorbed by the electrostatic chuck, and a total of a cross-sectional area of the cooling flow path is equal to or greater than 30% of an area of the internal electrode.

4. The electrostatic chuck according to claim 1, wherein, in dielectric layers provided on both sides in the thickness direction, the cooling flow path communicates with only one dielectric layer provided on one side of the internal electrode in the thickness direction.

5. The electrostatic chuck according to claim 1, wherein a second cooling flow path passing through the internal electrode in the thickness direction is further provided from one side of the internal electrode in the thickness direction toward the other side of the internal electrode in the thickness direction at a position different from the cooling flow path.

6. The electrostatic chuck according to claim 1, wherein the dielectric layer includes a resin layer on at least one side of the internal electrode in the thickness direction.

7. The electrostatic chuck according to claim 1, wherein the dielectric layer includes a resin film layer on at least one side of the internal electrode in the thickness direction.

8. The electrostatic chuck according to claim 1, wherein the dielectric layer has a ceramic layer on a side where an object adsorbed by the electrostatic chuck is disposed.

9. The electrostatic chuck according to claim 8, wherein the ceramic layer may or may not have gas vent holes in an adhesive surface of the object, but has no irregularities other than the gas vent holes.

10. The electrostatic chuck according to claim 1, further comprising a base provided on one side of the internal electrode in the thickness direction via the dielectric layer.
